Europäisches Patentamt

European Patent Office

Office européen des brevets

(19)

(11) Publication number: **0 379 013**
**A2**

# EUROPEAN PATENT APPLICATION

(21) Application number: **90100239.4**

(22) Date of filing: **05.01.90**

(51) Int. Cl.⁵: **B41F 15/08**

(30) Priority: **17.01.89 JP 8376/89**
**09.10.89 JP 263291/89**

(43) Date of publication of application:
**25.07.90 Bulletin 90/30**

(84) Designated Contracting States:
**AT BE CH DE DK ES FR GB GR IT LI LU NL SE**

(71) Applicant: **SANYO ELECTRIC CO., LTD.**
**2-18, Keihan-hondori**
**Moriguchi-shi Osaka(JP)**

(72) Inventor: **Aoki, Akira**
**956-E3-1, Ohazayoshida Ohizumimachi**
**Ohra-gun, Gunma-ken(JP)**
Inventor: **Masuda, Sadao**
**20-32, Ohazashimokobayashi**
**Ohta-shi, Gunma-ken(JP)**
Inventor: **Kawai, Akihiro**
**57-1-8-303, Ohazasumiyoshi, Ohizumimachi**
**Ohra-gun, Gunma-ken(JP)**

(74) Representative: **Schaumburg, Thoenes &**
**Englaender**
**Mauerkircherstrasse 31 Postfach 86 07 48**
**D-8000 München 86(DE)**

(54) **Screen printing method and printing machine.**

(57) A screen printing machine for, when a coating agent is coated on a print substrate having a circuit pattern through a screen, relatively positioning the screen and the substrate. A center point of correction for the relative positioning between the screen and the substrate is a suitable position.

EP 0 379 013 A2

# SCREEN PRINTING METHOD AND PRINTING MACHINE

## BACKGROUND OF THE INVENTION

### Field of the Invention

The present invention relates to a screen printing machine for, when a coating agent is coated on a print substrate having a circuit pattern through a screen, relatively positioning said screen and said substrate.

### Description of the Prior Art

As a prior art, Japanese Patent Application Laid-Open No. 63-62731 (U.S. Patent No. 4,864,361) previously filed by the present applicant discloses the art in which a positioning mark put on a substrate is recognized by a recognition camera, and the substrate and a screen are relatively positioned using a center of the substrate as a center of correction on the basis of the result of the recognition.

However, it is impossible to coincide all points on the substrate with the screen due to the irregularity of dimension of the substrate and the difference of process dimension.

For example, when a cream solder is printed in order to temporarily fix leads of parts such as SOP (Small Outline Package), QFP (Quad Flat Package) and the like with leads derived parallelly from the body side of an electronic part and in case where there are relatively dense portions and sparse portions of arrangements of parts on the substrate, when the parts are corrected and moved uniformly, parts adjacent to each other sometimes become contacted in the dense portions. Furthermore, in a substrate on which large parts and small parts are present in a mixed state, printing for the small parts was sometimes done on an unexpected portion because of the distance of correction.

Therefore, it is necessary that a reference point of printing, most requiring precision within the substrate, that is, a center point of correction, is set to a suitable position, and the screen is placed in coincidence with the substrate at the center point of correction.

## SUMMARY OF THE INVENTION

It is an object of the present invention to provide a screen printing machine for, when a coating agent is coated on a print substrate having a circuit pattern through a screen, relatively positioning the screen and the substrate, wherein a center point of correction for the relative positioning between the screen and the substrate comprises a suitable position.

According to the present invention, there is provided a screen printing machine for, when a coating agent is coated on a print substrate having a circuit pattern through a screen, relatively positioning said screen and said substrate, comprising a first memory means for storing a position of a theoretical positioning mark of said substrate and a position of a theoretical positioning center point of correction suitably set, a recognition camera for recognizing a positioning mark of a substrate for proofing, said circuit pattern and a print pattern after proofing and recognizing a positioning mark of a Fortdruck substrate, a second memory means for storing recognition data recognized by said camera, a first calculation means for calculating a position of a center point of correction corresponding to said theoretical center point of correction on the basis of comparison result of a position of a positioning mark recognized by said camera and a position of the theoretical positioning mark stored in said first memory means, a second calculation means for calculating a position of a center point of correction on the screen corresponding to said theoretical center point of correction on the basis of comparison result of a position of a circuit pattern recognized by said camera and a position of a print pattern, a third calculation means for calculating a dislocation amount by comparing a position of a center point of correction on the substrate calculated by said first calculation means with a center point of correction on the screen calculated by said second calculation means, a fourth calculation means for calculating a dislocation amount between said theoretical center point of correction and the center point of correction on said Fortdruck substrate calculated by said first calculation means on the basis of the result obtained by recognizing the positioning mark of the Fortdruck substrate by said camera, and a control means for correcting a relative position between the Fortdruck substrate and the screen on the basis of a dislocation amount in consideration of the calculation result by said fourth calculation means and the calculation result by said third calculation means.

A position of a positioning mark of a substrate for proofing is recognized by a recognition camera and is then compared with a position of a theoretical positioning mark stored in the first memory means, and a position of a center point of correction on the substrate corresponding to a theoretical center point of correction.

A position of a center point of correction on the screen is calculated by the second calculation means on the basis of the comparison result between a position of a circuit pattern recognized by said camera and a position of a print pattern, and a dislocation amount is calculated by the third calculation means by comparing a position of a center point of correction on the substrate calculated by said first calculation means with a center point of correction on the screen calculated by the second calculation means.

On the other hand, a positioning mark of the Fortdruck substrate is recognized by the camera, and the fourth calculation means calculates a dislocation amount between the theoretical center point of correction and a center point of correction on the Fortdruck substrate calculated by the first calculation means, and the control means performs a relative positioning between the Fortdruck substrate and the screen on the basis of a dislocation amount in consideration of the calculation result by the fourth calculation means and the calculation result by the third calculation means.

## BRIEF DESCRIPTION OF THE DRAWINGS

FIGS. 1 and 2 are a schematic block diagram and a plan view, respectively, of a screen printing machine to which a first embodiment according to the present invention is applied;

FIG. 3 a plan view schematically showing the operating state of a substrate-position adjusting mechanism in the printing machine according to the present invention;

FIGS. 4 to 8 respectively show the positioning operation of the substrate;

FIG. 9 is a flow chart showing the operation of the first embodiment according to the present invention; and

FIG. 10 shows the positioning operation of the substrate according to an other embodiment.

## DETAILED DESCRIPTION OF THE PREFERRED EMBODIMENTS

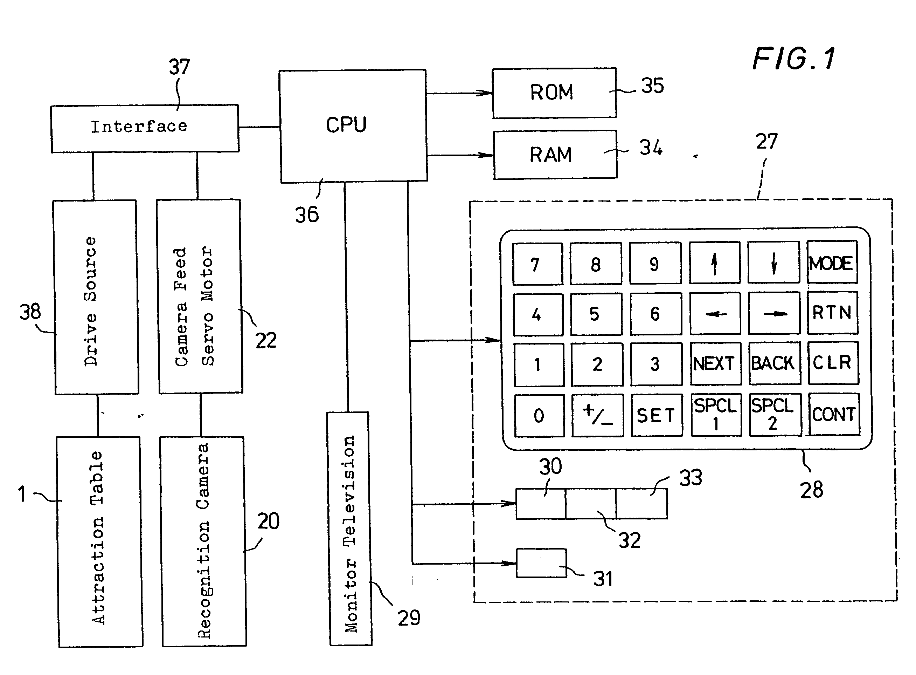

A first embodiment according to the present invention will be described in detail hereinafter with reference to FIGS. 1 to 9.

A print substrate 2 having positioning marks 2A and 2B put thereon and being carried by a substrate carrier not shown from the upstream (lefthand on the paper surface) is attracted by and placed on an attraction table 1, which is placed in a half-locked state on a moving table 1A. The moving table 1A is movably arranged on a pair of front and rear guide rails 3 and 4 along the direction of X which constitute a linear motion mechanism in a direction of X and is threadedly connected through a connecting member 7 to an X-direction output shaft 6 formed with feed threads driven by an X-direction feed servo motor 5 arranged parallel to the one guide rail 3 so that the output shaft 6 is normally and reversely rotated to control movement of the moving table 1A and the attraction table 1 in the direction of X from a positioning station A to a printing station B.

The attraction table 1 is connected to a pair of left and right first and second support shaft members 10 and 11 along the direction of Y and first and second fitting members 14 and 15 supported one of which is fitted rotatably in a horizontal direction ( $\theta$ direction) through shafts 12 and 13 secured to sliding portions 10A and 11A of the first and second support shaft members 10 and 11, the first and second support shaft members 10 and 11 being slidably disposed on guide rails 16 and 17 along the first and second Y directions and Y-direction output shafts 8 and 9, the other of the first and second fitting members 14 and 15 being secured to both left and right portions of the attraction table 1.

The shaft 12 is completely fitted in the first fitting member 14, and the second fitting member 15 has its outer portion notched to provide a play in a fitted state with respect to the shaft 13. Because of this, even if the distance between the shafts 12 and 13 is varied due to the variation of the moving distance of the support shaft members 10 and 11, the fitting state between the shaft 11 and the second fitting member 15 varies within the range of the aforesaid play, and the attraction table 1 is smoothly rotated in a direction of $\theta$ with respect to the moving table 1A.

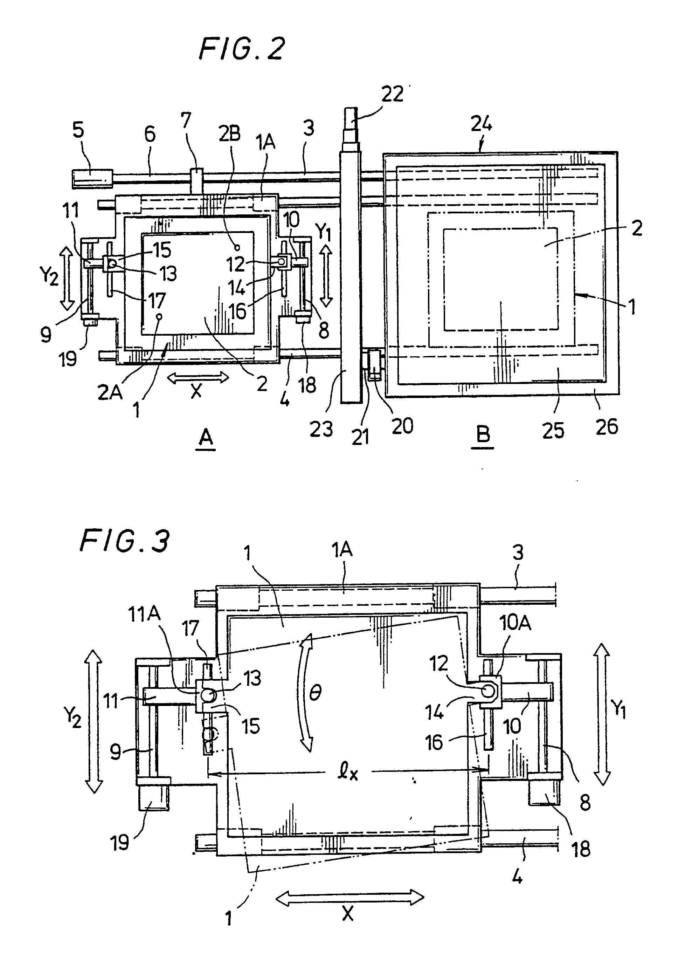

That is, the first support shaft member 10 causes the first Y-direction output shaft $\theta$ to be normally and reversely rotated by means of a first correcting servo motor 18 to thereby move the right side of the attraction table 1 in a direction of $Y_1$ and makes it possible to control rotation thereof in a direction of $\theta$ about the shaft 12 whereas the second support shaft member 11 causes the second Y-direction output shaft 9 to be normally and reversely rotated by means of a second correcting servo motor 19 to thereby move the left side of the attraction table 1 in a direction of $Y_2$ and makes it possible to control rotation thereof in a direction of about the shaft 13. Then, the attraction table 1 is rotated in a direction of $\theta$ about the shafts 12 and 13 due to the difference in displacement in the directions of $Y_1$ and $Y_2$ as shown by the dotted line in FIG. 3. These components serve as a Y-direction linear motion mechanism to constitute a $\theta$-direction rotational motion mechanism to adjust a position of the substrate 2 together with the X-direction linear motion mechanism.

Reference numeral 20 designates a single recognition camera. The recognition camera 20 is connected through a connecting member 21 to a moving mechanism 23 which is moved in a direction of Y by means of a camera feed servo motor 22. The moving mechanism 23 is disposed directly above the guide rails 3 and 4 and is provided with an output shaft not shown which is normally and reversely rotated by the camera feed servo motor 22. The connecting member 21 is threadedly connected to the output shaft to thereby move the recognition camera 20 in a direction (Y direction) perpendicular to the carrier direction (X direction) of the substrate 2.

A print screen indicated at 24 is arranged at a position above the printing station B on the righthand of the guide rails 3 and 4. The print screen 24 comprises a screen plate 25 and a screen frame 26 surrounding the screen plate 25.

An operating portion indicated at 27 comprises a keyboard 28 as an input device for setting various data, a teach key 30 as an image plane selection key for a monitor television 29, a start key 31 for starting the screen printing machine, a manual key 32 for manually causing the printing operation, an automatic key 33 and the like.

Reference numeral 34 designates a RAM as a memory device in which various set data such as positioning marks 2A and 2B of the substrate 2 and the like are stored.

Reference numeral 35 designates a ROM in which data in connection with the printing operation are stored.

Reference numeral 36 designates a CPU as a controller, which performs determined control in accordance with the aforesaid various set data.

Reference numeral 37 designates an interface.

A drive source 38 for driving the attraction table 1 is composed of the X-direction feed servo motor 5, the first correcting servo motor 18 and the second correcting servo motor 19.

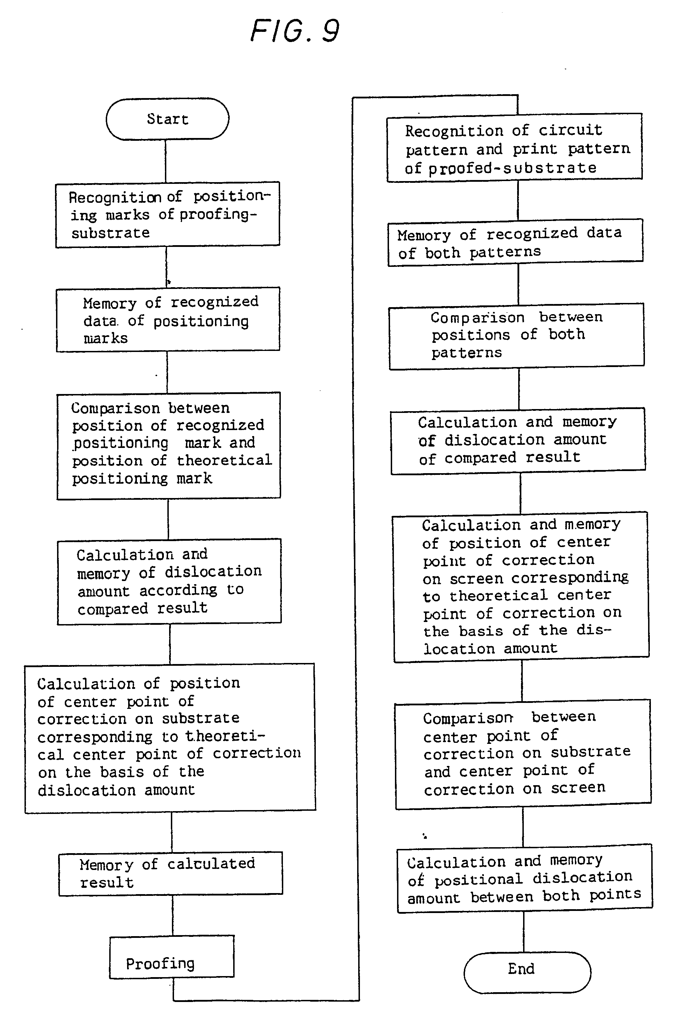

The operation will be described in detail with particular reference to FIG. 9.

First, in the positioning station A, when the start key 31 and the manual key 32 are operated, the substrate 2 for proofing carried by the substrate carrier device is placed on the attraction table 1. The substrate 2 after having been positioned and attracted by a positioning mechanism not shown is moved to the recognition station by moving the moving table 1A and the attraction table 1 in the direction of X by the driving of the X-direction feed servo motor 5 which has the feed function as well as the correction function to assume a position below the recognition camera 20. At this time, the moving position of the attraction table 1 is set in the RAM 34 so that the positioning mark 28 put on the substrate 2 having the positional data stored therein is fed to the position directly below the recognition camera 20. Accordingly, the servo motor 22 for movement of the recognition camera 20 and the servo motor 5 for movement of the moving table 1A are controlled by the CPU 36, and the positioning mark 28 of the substrate 2 is to be positioned directly below the camera 20. Under this state, the positioning mark 2B is recognized by the recognition camera 20, the positioning mark 2A is then likewise positioned directly below the recognition camera 20 and recognized, and positions (2A1x, 2A1y)(2B1x, 2B1y) of the positioning marks 2A and 2B are recognized, which are stored as data in RAM 34. The aforesaid recognition data and positions $(2A'1x, 2A'1y)(2B'1x, 2B'1y)$ of theoretical positioning marks $(2A')(2B')$ stored in the RAM 34 are compared by a comparison device not shown within the CPU 36, and a dislocation amount thereof is likewise calculated by a computer not shown. That is, a dislocation amount of the positioning mark 2A in the direction of X with respect to $2A'$ is $2A1x - 2A'1x$, and a dislocation amount thereof in the direction of Y is $2A1y - 2A'1y$, whereas a dislocation amount of the positioning mark 2B in the direction of X with respect to $2B'$ is $2B1x - 2B'1x$, and a dislocation amount thereof in the direction of Y is $2B1y - 2B'1y$, which are stored in the RAM 34. The position of the center point $S_2$ of correction on the substrate 2 corresponding to the positions $(S^1{}_x, S_{1y})$ of the theoretical center point $S_1$ of correction suitably set to RAM 34 by an user is calculated on the basis of the dislocation amount by use of a computer. First, an angular dislocation amount $(\theta_1)$ of the recognized substrate 2 with respect to the theoretical inclination in case where the latter is zero degree is given by

$$\theta_1 = atn [(2A 1y - 2B 1y) / (2A 1x - 2B 1x)] - atn [-(2A'1y - 2B'1y) / (2A'1x - 2B'1x)] \qquad (1)$$

Next, positions $(S_{2x}, S_{2y})$ of a center point $S_2$ of correction on the actual substrate 2 are obtained by

$$S_{2x} = (S_{1x} - Cxn) \cdot xs\text{-}t \cdot cos (\theta_1) - (S_{1y} - Cyn) \cdot ys\text{-}t \cdot sin (\theta_1) + cdx + cxn \qquad (2)$$

$$S_{2y} = (S_{1y} - cyn) \cdot ys\text{-}t \cdot cos (\theta_1) + (S_{1x} - cxn) \cdot xs\text{-}t \cdot sin (\theta_1) + cdy + cyn \qquad (3)$$

where

cxn, cyn : Center coordinate of the theoretical position-marks $2A'$ and $2B'$

xs-t, ys-t: Coefficient of extension of the substrate 2 in the directions of X and Y (both of which are the same)

cdx, cdy : Dislocation amounts of the substrate 2 in the directions of X and Y from cxn and cyn

The data in connection with the angular dislocation amount ($\theta_1$) and the positions $(S_{2x}, S_{2y})$ of the center point $S_2$ of correction on the actual substrate 2 are stored in the RAM 34.

Thereafter, the moving table A and the attraction table 1 are moved in the direction of X by the servo motor 5 and moved to the printing station B and thereafter moved upward by an elevating mechanism not shown. The proofing substrate 2 is positioned close to the screen plate 25 and thereafter a cream solder as a coating agent is coated on the substrate 2 through the screen plate by means of squeezee not shown without being accompanied by the correcting movement, thus performing proof printing.

The substrate 2 having been subjected to proofing is again returned to the recognition station and reset. Positions of (two) circuit patterns to be printed on the substrate 2 and positions of print patterns actually printed are recognized by use of the recognition camera 20 as previously mentioned. The data $(2C1x, 2C1y)$ $(2C'1x, 2C'1y)$ and $(2D1x, 2D1y)(2D'1x, 2D'1y)$ in connection with the positions of both the patterns are stored in the RAM 34.

Then, comparison is made by a comparison device incorporated within the CPU 36 and the dislocation amount of the positions of both the patterns is calculated by a computer. The dislocation amounts in the direction of X according to the calculation result are $2C1x - 2D1x$ and $2C'1x - 2D'1x$, and the dislocation amounts in the direction of Y are $2C1y - 2D1y$ and $2C'1y - 2D'1y$. Positions of a center point $S_2$ of correction on the substrate 2 having been subjected to proofing corresponding to the theoretical center point $S_1$ of correction and a center point $S_3$ of correction on the screen plate 25 corresponding to the theoretical center point $S_1$ of correction are compared by the comparison device, and the dislocation amount is calculated by the computer. That is, the angular dislocation amount ( $\theta_s$) of the substrate 2 with respect to the screen plate 25 is given by

$$\theta_s = atn [(2C1y - 2C'1y) / (2c1y - 2C'1x) - atn [-(2D1y - 2D'1y) / (2D1x - 2D'1x)]$$

Assume that the position of center point $S_3$ of correction on the screen plate 25 is $(S_{3x}, S_{3y})$, then

$$S_{3x} = (S_{2x} - Cxn') \cdot xs\text{-}t' \cdot \cos (-\theta_s) - (S_{2y} - cyn') \cdot ys\text{-}t' \cdot \sin (-\theta_s) + cdx_o + cxn'$$
$$S_{3y} = (S_{2y} - cyn') \cdot \cos (-\theta_s) + (S_{2x} - cxn') \cdot xs\text{-}t' \cdot \sin (-\theta_s) + cdy_o - cyn'$$

where
$cxn'$ $cyn'$ : Center coordinate of two points of a circuit pattern to be printed on the substrate 2
$xs\text{-}t'$, $ys\text{-}t'$ : Coefficient of extension of the screen plate 25 in the directions of X and y (both of which are the same)
$cdx_o$, $cdy_o$ : Dislocation amounts in the directions of X and Y of the screen plate 25 from cxn and cyn

On the other hand, the angular dislocation amount ( $\theta_1$) of the recognized substrate 2 with respect to the theoretical inclination in case where the latter is zero degree is as given by the aforementioned formula (1), and the postions $(S_{2x}, S_{2y})$ of the center point $S_2$ of correction on the substrate are as given by the aforementioned formulae (2) and (3).

As described above, among the dislocation amounts to be moved in correction, the dislocation amount of angle is $\theta_s$. Positions (qx, qy) capable of presuming that when the substrate 2 is corrected through $\theta_s$ with the center of the substrate 2 being a center point of correction, the center point $S_2$ of correction on the substrate 2 is moved and positioned are given by

$$qx = S_{2x} \cdot \cos ( \theta_1 - \theta_s) - S_{2y} \cdot \sin (\theta_1 - \theta_s)$$
$$qy = S_{2y} \cdot \cos (\theta_1 - \theta_s) + S_{2y} \cdot \sin (\theta_1 - \theta_s)$$

Let dx1 be the correction amount in the direction of X, dy1 be the correction amount in the direction of $Y_1$ and dyz be the correction amount in the direction of $Y_1$, then,

$$dx1 = qx - S_{3x}$$
$$dy1 = (qy - S_{3y}) + l_x \cdot \tan (\theta_1 - \theta_s)$$
$$dy2 = qy - S_{3y}$$

where $l_x$ represents the distance between the centers of the support shafts 12 and 13.

In this case, the correction amount dx1 is to coincide the X coordinate $S_{2x}$ of the center point $S_2$ of correction of the substrate 2 with the X coordinate $S_{3x}$ of the center point $S_3$ on the screen plate 25, the correction amount dy1 is to coincide the Y coordinate $S_{2y}$ of the center point $S_2$ of correction with the Y coordinate $S_{3y}$ of the center point $S_3$ of correction to correct the angular dislocation amount $\theta_s$, and the final correction amount dyz is to coincide the Y coordinate $S_{2y}$ of the center point $S_2$ of correction with the Y coordinate $S_{3y}$ of the center point $S_3$ of correction.

As described above, the dislocation amount are divided into the directions of X, $Y_1$ and $Y_2$, which are stored in the RAM 34. This can be considered as mechanical characteristics in construction of the screen printing machine.

Next, in case where the start key 31 and the automatic key 33 are operated to effect a new printing on the print substrate 2, the X-direction feed servo motor 5 and the camera feed servo motor 22 are controlled by the CPU 36 as previously mentioned to recognize positions $(2A''1x, 2A''1y)$ and $(2B''1x, 2B''1y)$ of the positioning marks 2A and 2B on the substrate 2 to store them in the RAM 34.

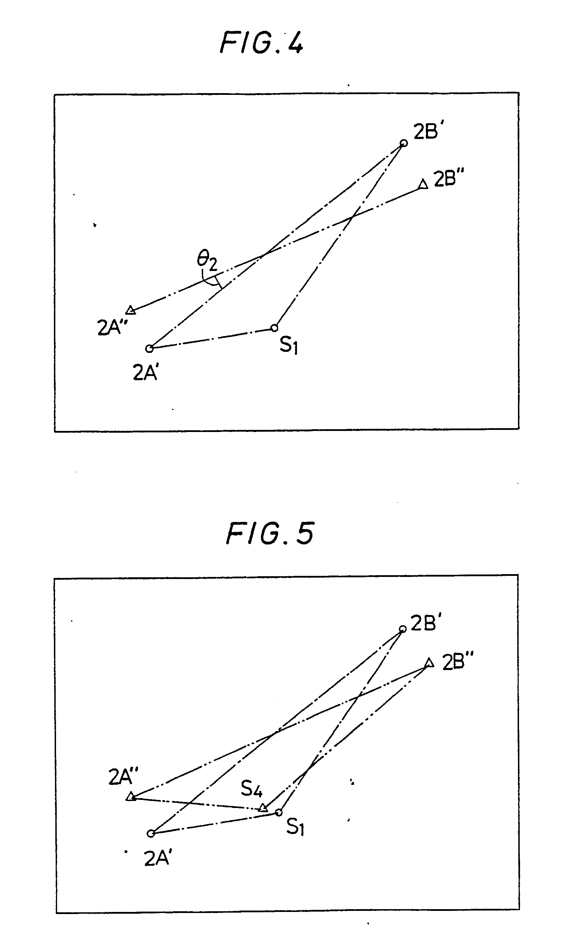

The recognized data and the positions $(2A'1x, 2A'1y)$ and $(2B'1x, 2B'1y)$ of the theoretical positioning marks 2A' and 2B' already stored in the RAM 34 are compared by the comparison device, and the dislocation amount thereof is calculated by the computer. That is, the dislocation amount in the direction of X is $2A''1x - 2A'x$ and $2B''1x - 2B'1$, and the dislocation amount in the direction of Y is $2A''1y - 2A'1y$ and $2B''1y - 2B'1y$. The position of

the center point $S_2$ of correction on the substrate 2 corresponding to the position ($S_{1x}$, $S_{1y}$) of the theoretical center point $S_1$ of correction suitably set to the RAM 34 by an user is calculated by the computer on the basis of the dislocation amounts. The angular dislocation amount ($\theta_2$) of the recognized substrate 2 with respect to the theoretical data is given by (see FIG. 4.)

$\theta_2$ = atn [($2A''1y - 2B''1y$) / ($2A''1x - 2B''1x$)] -atn [-($2A'1y - 2B'1y$) / ($2A'1x - 2B'1x$)]

Next, positions ($S_{4x}$, $S_{4y}$) of the center point $S_4$ of correction on the actual substrate 2 are obtained by

$S_{4x}$ = ($s_{1x} - cxn$) · xs-t'' · cos ($-\theta_2$) - ($S_{1y} - cyn$) · ys-t'' · sin ($-\theta_2$) + cdx' + cxn

$S_{4y}$ = ($S_{1y} - cyn$) · ys-t'' · (cos ($-\theta_2$) + ($S_{1x} - cxn$) · xs-t'' · sin ($-\theta_2$) + cdy' + cyn

where

cxn, cyn : Center coordinate of the theoretical positioning marks $2A'$ and $2B'$

xs-t'', ys-t'': Coefficient of extension of the substrate 2 in the directions of X and Y (both of which are the same)

cdx', cdy' : Dislocation amounts in the directions of X and Y from cxn and cyn

The data in connection with the angular dislocation amount ($\theta_2$) and the positions ($S_{4y}$, $S_{4y}$) of the center point $S_4$ of correction on the actual substrate 2 are stored in the RAM 34.

The dislocation amount between the theoretical center point $S_1$ of correction and the center point $S_4$ of correction on the substrate 2 is divided in the directions of X, $Y_1$ and $Y_2$ as follows:

d'y1 = ($S_{1y} - S_{4y}$) + $lx$ · tan ($\theta_2$)

d'y2 = $S_{1y} - S_{4y}$

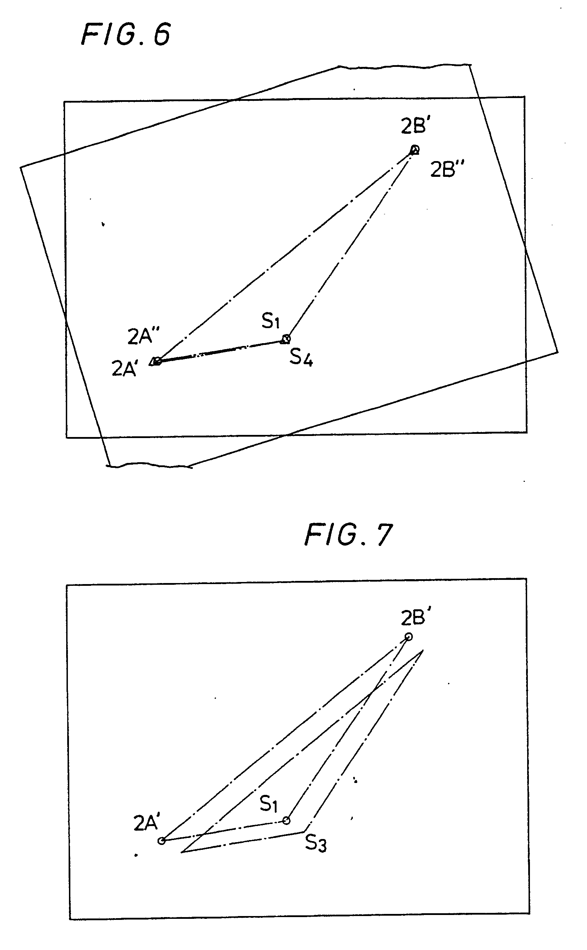

(See FIG. 6)

The correction amounts dx1, dy1 and dy2 obtained from the relationship between the theoretical center point $S_1$ of correction and the screen plate 25 when proofing was done as previously mentioned are given by

dx1 : qx - $S_{3x}$

dy1 : (qy - $S_{3y}$) + x · tan ($\theta_5$)

dy2 : qy - $S_{3y}$

(see FIG. 7).

Therefore, the final correction amount of the Fortdruck substrate 2 is obtained by

d''x1 - dx1 + d'x1 = (qx - $S_{3x}$) + ($S_{1x} - S_{4x}$)

d''y1 = dy1 + dy1 = [(qy - $S_{3y}$) + $lx$ · tan ($\theta_5$)] + [($S_{1y} - S_{4y}$) + $lx$ · tan ($\theta_2$)]

d''y2 = dy2 + d'y2 = (qy - $S_{3y}$) + ($S_{1y} - S_{4y}$)

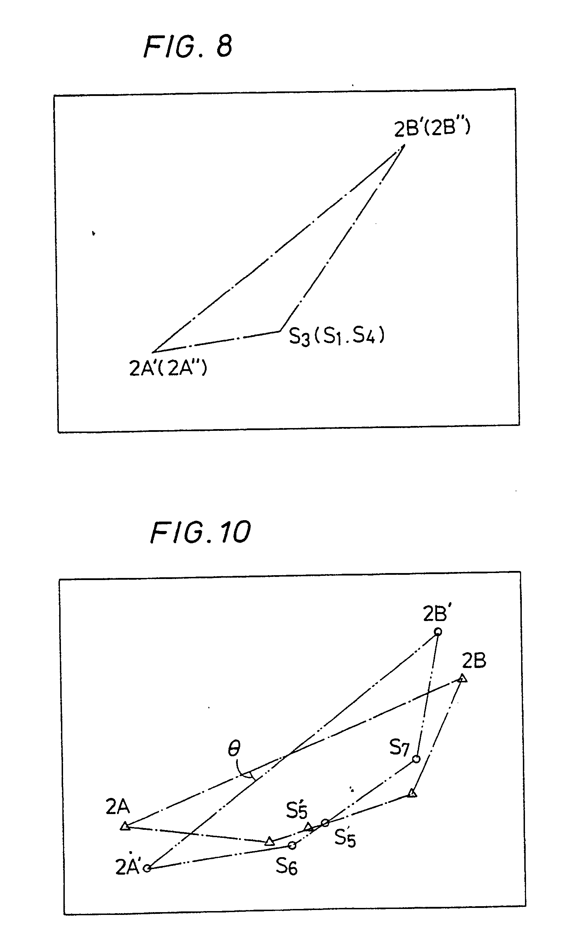

(see FIG. 8)

These are stored in the RAM 34.

The thus determined correction amounts in the directions of X, Y and $\theta$ are corrected after the tables have been moved to the printing stations B and moved upward by an elevating mechanism not shown. That is, the correction of the attraction table 1 in the direction of X is accomplished by controlling the X-direction feed servo motor 5 through the correction amount d''x1, and the correction thereof in the direction of Y and $\theta$ is accomplished by moving the support shaft members 10 and 11 along the Y-direction output shafts 8 and 9 and the guide rails 16 and 17 through the correction amounts d''y1 and d''y2, respectively, by the first and second correcting servo motors 18 and 19 and correcting and moving the attraction table 1 to a normal position through the fitting members 14 and 15.

It is to be noted that with respect to the correction and movement in the directions of X, Y and $\theta$, correction in the directions of X and Y may be accomplished after correction in the direction of $\theta$, and correction in the direction of Y may be accomplished in the direction of $\theta$.

A cream solder is coated on the substrate 2 through the screen plate 25 by a squeezee not shown so as to apply screen printing having a predetermined wiring pattern without positional dislocation (see FIG. 8).

With respect to the correcting operation, when the attraction table 1 is moved toward the printing station B, correction in the direction of X is accomplished, and after moving operation and after upward moving operation, correction in the directions of Y and $\theta$ may be accomplished.

Furthermore, while the X-direction feed servo motor 5, the first correcting servo motor 18 and the second correcting servo motor 19 have been used as drive sources, it is to be noted that a pulse motor may be used.

Next, the case where there are two points different in precision demand of correction and correction is made while enhancing the precision at these points will be described hereinafter with reference to FIG. 10.

The positions (2A1x, 2A1y) (2B1x, 2B1y) of the positioning marks 2A and 2B are recognized and stored in the RAM 34 as described above. The recognized data and the positions (2A'1x, 2A'1y) (2B'1x, 2B'1y) of the theoretical positioning marks 2A' and 2B' stored in the RAM 34 are compared, and the dislocation amount thereof is calculated by the computer and stored.

A theoretical center point $S_5$ of correction when the attraction table 1 is corrected and moved will be described. If precisions at important points $S_6$ and $S_7$ are 0.1 mm and 0.3 mm, respectively, the ratio of precision is 1 : 3, and a point subjected to interior division according to the ratio is a center point $S_5$ of correction.

Accordingly, judging from the positions ($S_{6x}$, $S_6y$) of the theoretical important point $S_6$ and the positions ($S_{7x}$, $S_{7y}$) of the important point $S_7$, the positions ($S_{5x}$, $S_{5y}$) of the theoretical center point

$S_5$ of correction are given by

$$S_{5x} = S_{6x} + 0.1 (S_{7x} - S_{6x}) / (0.1 + 0.3) \qquad (4)$$
$$S_{5y} = S_{6y} + 0.1 (S_{7y} - S_{6y}) / (0.1 + 0.3) \qquad (5)$$

Positions $(S'_{5x}, S'_{5y})$ of a center point $S'_5$ of correction on the substrate 2 corresponding to the positions $S_{5x}, S_{5y})$ of the theoretical center point $S_5$ of correction are obtained, while considering the relationship with the marks 2A, 2B and 2A', 2B', as follows:

$$S'_{5x} = 2A1x - (2A'1x \cdot \cos \cdot \theta + 2A'1y \cdot \sin \theta) + (S_{5x} \cdot \cos \theta + S_{5y} \cdot \sin \theta) \qquad (6)$$
$$S'_{5y} = (S_{5y} \cdot \cos \theta - S_{5x} \cdot \sin \theta) + 2A1y - (2A'1y \cdot \cos \theta - 2A'1x \cdot \sin \theta) \qquad (7)$$

On the other hand, the angular dislocation $(\theta)$ in the dislocation amount with respect to the marks 2A, 2B and 2A', 2B' is given by
$$\theta = atn \left[ (2A1y - 2B1y) / (2A1x - 2B1x) \right] - atn \left[ -(2A'1y - 2B'1y) / (2A'1x - 2B'1x) \right] \qquad (8)$$
which is similar to the case previously mentioned.

As described above, according to the present invention, the screen and the substrate can be adjusted in position with a suitable set position as a center point of correction. Therefore, correction adjusted to a point (area) which particularly requires a high precision can be made, and screen printing is conveniently carried out.

## Claims

1. In a screen printing machine for, when a coating agent is coated on a print substrate having a circuit pattern through a screen, relatively positioning said screen and said substrate, a screen printing method characterized in that a center point of correction for the relative positioning between said screen and said substrate is a suitable position.

2. A screen printing machine for, when a coating agent is coated on a print substrate having a circuit pattern through a screen (24), relatively positioning said screen (24) and said substrate (2), comprising a first memory means (34) for storing a position of a theoretical positioning mark (2A', 2B') of said substrate (2) and a position of a theoretical positioning center point $(S_1)$ of correction suitably set, a recognition camera (20) for recognizing a positioning mark (2A, 2B) of a substrate (2) for proofing, said circuit pattern and a print pattern after proofing and recognizing a positioning mark (2A, 2B) of a Fortdruck substrate (2), a second memory means (34) for storing recognition data recognized by said camera (20), a first calculation means (36) for calculating a position of a center point $(S_2)$ of correction corresponding to said theoretical center point $(S_1)$ of correction on the basis of comparison result of a position of a positioning mark (2A, 2B) recognized by said camera (20) and a position of the theoretical positioning mark (2A', 2B') stored in said first memory means (34), a second calculation means (36) for calculating a position of a center point $(S_3)$ of correction on the screen (24) corresponding to said theoretical center point $(S_1)$ of correction on the basis of comparison result of a position of a circuit pattern recognized by said camera (20) and a position of a print pattern, a third calculation means (36) for calculating a dislocation amount by comparing a position of a center point $(S_2)$ of correction on the substrate (2) calculated by said first calculation means with a center point $(S_3)$ of correction on the screen (24) calculated by said second calculation means (36), a fourth calculation means (36) for calculating a dislocation amount between said theoretical center point $(S_1)$ of correction and the center point $(S_4)$ of correction on said Fortdruck substrate calculated by said first calculation means (36) on the basis of the result obtained by recognizing the positioning mark (2A, 2B) of the Fortdruck substrate by said camera, and a control means (36) for correcting a relative position between the Fortdruck substrate (2) and the screen (24) on the basis of a dislocation amount in consideration of the calculation result by said fourth calculation means (36) and the calculation result by said third calculation means (36).

*FIG.1*

Interface — 37

CPU

ROM — 35

RAM — 34

36

38 — Drive Source

Camera Feed Servo Motor — 22

27

1 — Attraction Table

20 — Recognition Camera

Monitor Television — 29

| 7 | 8 | 9 | ↑ | ↓ | MODE |
| 4 | 5 | 6 | ← | → | RTN |
| 1 | 2 | 3 | NEXT | BACK | CLR |
| 0 | +/− | SET | SPCL 1 | SPCL 2 | CONT |

30

33

32

31

28

EP 0 379 013 A2

*FIG. 2*

*FIG. 3*

## FIG. 4

## FIG. 5

## FIG. 6

## FIG. 7

## FIG. 8

## FIG.10

# FIG. 9

Start

↓

Recognition of position-
ing marks of proofing-
substrate

↓

Memory of recognized
data of positioning
marks

↓

Comparison between
position of recognized
positioning mark and
position of theoretical
positioning mark

↓

Calculation and
memory of dislocation
amount according to
compared result

↓

Calculation of position
of center point of
correction on substrate
corresponding to theoreti-
cal center point of correction
on the basis of the
dislocation amount

↓

Memory of calculated
result

↓

Proofing

Recognition of circuit
pattern and print pattern
of proofed-substrate

↓

Memory of recognized data
of both patterns

↓

Comparison between
positions of both
patterns

↓

Calculation and memory
of dislocation amount
of compared result

↓

Calculation and memory
of position of center
point of correction
on screen corresponding
to theoretical center
point of correction on
the basis of the dis-
location amount

↓

Comparison between
center point of
correction on substrate
and center point of
correction on screen

↓

Calculation and memory
of positional dislocation
amount between both points

↓

End